# EUROPEAN PATENT SPECIFICATION

(11) **EP 4 174 433 B1**
(45) Date of publication and mention of the grant of the patent: **18.03.2026**
(21) Application number: 22204246.7
(22) Date of filing: 27.10.2022
(51) Int. Cl.: F28F 3/12, H05K 7/20

(54) **HEATING VENTILATION AND AIR CONDITIONING SYSTEM WITH HEAT EXCHANGER FOR POWER ELECTRONICS**
HEIZUNG, LÜFTUNG UND KLIMAANLAGE SYSTEM MIT WÄRMETAUSCHER FÜR LEISTUNGSELEKTRONIK
CHAUFFAGE VENTILATION ET CLIMATISATION SYSTÈME AVEC ÉCHANGEUR DE CHALEUR POUR ÉLECTRONIQUE DE PUISSANCE

(30) Priority: 27.10.2021 US 202163272359 P
(43) Date of publication of application: 03.05.2023
(73) Proprietor: Carrier Corporation, Palm Beach Gardens, FL 33418 (US)
(72) Inventor: JOARDAR, Arindom, New York, 13057 (US); MOHANTA, Lokanath, New York, 13057 (US); BORISOV, Konstantin, Bloomfield, 06002 (US); AGIRMAN, Ismail, Bloomfield, 06002 (US)
(74) Representative: Dehns

(56) References cited:
- WO-A1-2013/105487
- DE-A1- 102019 118 356
- FR-A1- 2 702 830
- FR-A1- 3 105 382
- US-A- 5 978 220
- US-A1- 2009 250 195
- US-A1- 2013 058 041
- US-A1- 2020 373 223

## Description

### BACKGROUND

The present invention pertains to heating, ventilation, and air conditioning (HVAC) systems and the art of heat exchangers, and more particularly to heat exchangers for cooling power electronics in heating, ventilation, and air conditioning (HVAC) systems.

Power electronics devices such as motor drives generate waste heat during operation of the device. Additionally, when the power electronics devices heat up the operational efficiency of the devices can degrade adding to the amount of heat generated. When utilized in a refrigeration system to drive, for example, a compressor of the refrigeration system, effective thermal integration of these devices can be important aspect to the system's overall efficiency and reliability. Consequently, a goal of the system integrator is to maintain these components within a range of operating temperatures which will maximize the system efficiency. Accordingly, there remains a need in the art for heat exchangers configured to closely integrate with power electronic devices which can maintain optimal temperatures for these components under a variety of load conditions.

US 5978220 discloses a liquid cooling device for a high-power semiconductor module containing a plurality of heat-generating submodules arranged next to one another on a cooling surface. US 2009 250195 discloses a cooler for cooling a plurality of semiconductor elements joined to a plate member. US 2020373223 discloses a water block assembly for cooling computer systems. US 2013 058041 discloses a semiconductor module and cooler. DE 102019118356 discloses a battery temperature control system in which a refrigerant circuit comprises first and second expansion valves, a condenser and a compressor.

### BRIEF DESCRIPTION

According to a first aspect of the invention, a heating, ventilation, and air conditioning (HVAC) system according to claim 1 is provided. The heating, ventilation, and air conditioning (HVAC) system comprises a vapour compression circuit including a compressor, a condenser, an expansion device and an evaporator arranged in series and having a volume of refrigerant flowing therethrough, and a power electronics assembly. The power electronics assembly includes two or more power electronics devices, and a heat exchanger to which the two or more power electronics devices are mounted. The heat exchanger includes a plurality of fluid pathways extending through the heat exchanger to transfer thermal energy from the two or more power electronics devices into a flow of fluid passing through the plurality of fluid pathways. The two or more power electronics devices includes at least one power electronics device of the two or more power electronics devices located on each opposing lateral side of the heat exchanger. The flow of fluid passing through the plurality of fluid pathways is a flow of liquid refrigerant diverted from a condenser of a heating, ventilation, and air conditioning (HVAC) system. The refrigerant is diverted from the condenser, bypassing the expansion device of the HVAC system and is directed from the heat exchanger to the evaporator. The fluid flow exiting the one or more fluid pathways is directed through the evaporator prior to flowing through the compressor.

The heat exchanger may include multiple columns of the fluid pathways arranged between the opposing lateral sides of the heat exchanger.

Each column of the multiple columns of fluid pathways may define an independent fluid circuit.

Each column of fluid pathways may be configured to cool the at least one power electronics device of the two or more power electronics devices at the lateral side of the heat exchanger nearest each column.

The plurality of fluid pathways may include one or more fins extending inwardly from a pathway inner wall.

Each fin of the one or more fins may have a fin height in the range of 0.2 millimeters to 0.5 millimeters.

One or more condensate drainage passages may be formed in an exterior surface of the heat exchanger configured to drain condensate formed on one or more of the two or more power electronics devices or on the heat exchanger.

The one or more condensate drainage passages may have a T-shaped cross-section.

The plurality of fluid pathways may extend off of horizontal along a fluid pathway length.

According to a second aspect of the invention, a method of cooling two or more power electronics devices is provided according to claim 9. The method includes securing the two or more power electronics devices to a heat exchanger. The heat exchanger includes a plurality of fluid pathways. A flow of fluid is circulated through the plurality of fluid pathways to transfer thermal energy from the two or more power electronics devices to the flow of fluid passing through the plurality of fluid pathways. The flow of fluid is a flow of liquid refrigerant diverted from a condenser of a heating, ventilation, and air conditioning (HVAC) system. The refrigerant is diverted from the condenser, bypassing the expansion device of the HVAC system and is directed from the heat exchanger to the evaporator. The fluid flow exiting the one or more fluid pathways is directed through the evaporator prior to flowing through the compressor. At least one power electronics device of the two or more power electronics devices is located on each opposing lateral side of the heat exchanger.

The heat exchanger may include multiple columns of the fluid pathways arranged between the opposing lateral sides of the heat exchanger.

A first flow of fluid may be circulated through a first column of fluid pathways, and a second flow of fluid may be circulated through a second column of fluid pathways.

A first power electronics device located at a first lateral side of the heat exchanger may be cooled via the first flow of fluid and a second power electronics device located at a second lateral side of the heat exchanger may be cooled via the second flow of fluid.

The plurality of fluid pathways may include one or more fins extending inwardly from a pathway inner wall.

Each fin of the one or more fins may have a fin height in the range of 0.2 millimeters to 0.5 millimeters.

Condensate formed on one or more of the two or more power electronics devices or on the heat exchanger may be drained via one or more condensate drainage passages formed in an exterior surface of the heat exchanger.

The one or more condensate drainage passages may have a T-shaped cross-section. The plurality of fluid pathways may extend off or horizontal along a fluid pathway length.

### BRIEF DESCRIPTION OF THE DRAWINGS

The following descriptions should not be considered limiting. Certain exemplary embodiments of the invention, will now be described, with reference to the accompanying drawings, in which like elements are numbered alike.
FIG. 1 shows an exemplary power electronics assembly;
FIG. 2 shows an exemplary heating, ventilation, and air conditioning (HVAC) system;
FIG. 3 shows a heat exchanger of an exemplary power electronics assembly;
FIG. 4 shows an exemplary heat exchanger having multiple fluid pathway columns;
FIG. 5 shows an exemplary heat exchanger having multiple fluid pathway columns;
FIG. 6 shows a cross-sectional view of an exemplary fluid pathway having internal fins;
FIG. 7 shows a perspective view of an exemplary fin structure;
FIG. 8 shows an exemplary helix angle of a fin of a fluid pathway;
FIG. 9 shows a cross-sectional view of an exemplary heat exchanger having condensate drainage passages; and
FIG. 10 shows a view of an exemplary heat exchanger showing an orientation of fluid pathways.

### DETAILED DESCRIPTION

A detailed description of one or more embodiments of the disclosed apparatus and method are presented herein by way of exemplification and not limitation with reference to the Figures.

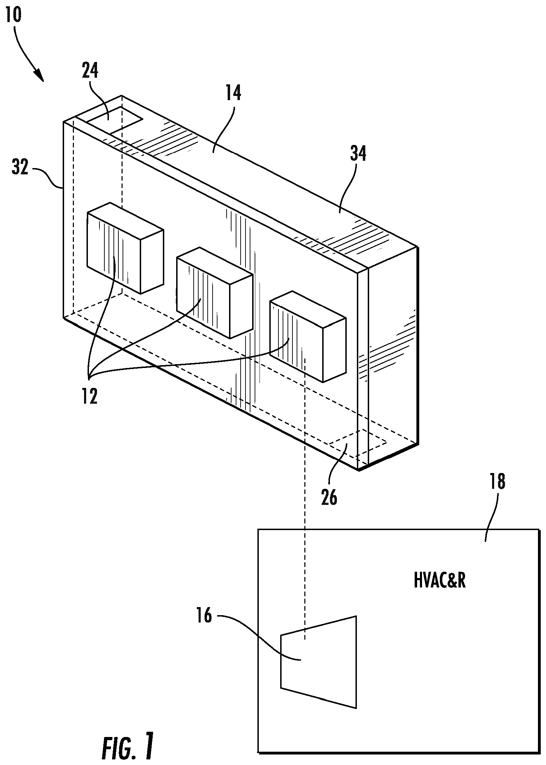

Illustrated in FIG. 1 is a power electronics assembly 10 used in an embodiment of a heating, ventilation, and air conditioning (HVAC) system. The power electronics assembly 10 includes two or more power electronics devices 12 mounted to a heat exchanger 14 utilized to reject and dissipate thermal energy generated by the power electronics devices 12 during operation. In some embodiments, the power electronics devices 12 include a variable frequency drive (VFD) operably connected to a compressor 16 of a heating, ventilation, and air conditioning (HVAC) system 18.

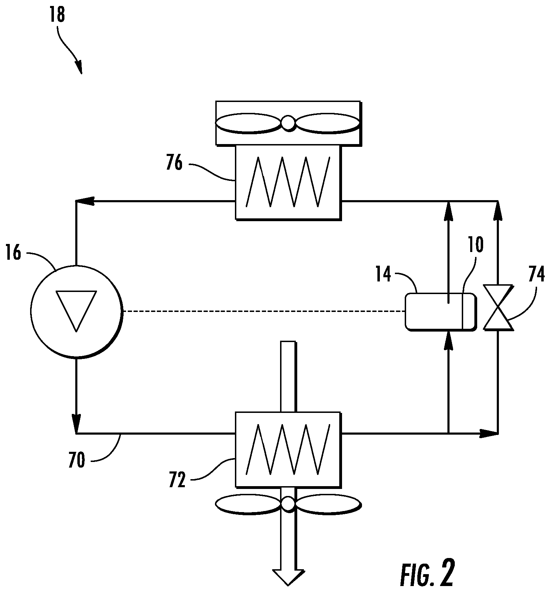

Referring to FIG. 2, the HVAC system 18 includes a vapor compression circuit 70 including the compressor 16, a condenser 72, an expansion device 74 and an evaporator 76 arranged in series and having a volume of refrigerant flowing therethrough. The power electronics assembly 10 is connected to the vapor compression circuit 70 such that a portion of the flow of liquid refrigerant exiting the condenser 72 is diverted through the heat exchanger 14, bypassing the expansion device 74 and is directed from the heat exchanger 14 to the evaporator 76. The liquid refrigerant from the condenser 72 absorbs thermal energy generated by the power electronics devices 12. This thermal energy generated by the power electronics devices 12 may cause the refrigerant passing through the heat exchanger 14 to boil, changing phase of the refrigerant from liquid to vapor inside the heat exchanger 14.

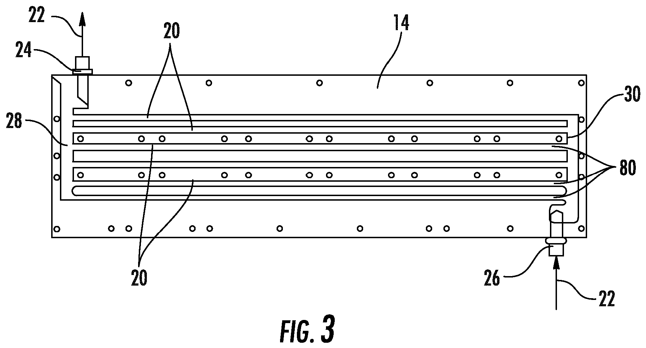

Referring now to FIG. 3, the exemplary heat exchanger 14 is illustrated in more detail. As shown, the heat exchanger 14 includes a plurality of enclosed fluid pathways 20 enabling a flow of fluid 22 such as, for example, refrigerant, glycol, or water to flow therein. The fluid pathways 20 extend between a heat exchanger inlet 26 through which the flow of fluid 22 enters the heat exchanger 14, and a heat exchanger outlet 24 through which the flow of fluid 22 exits the heat exchanger 14. The heat exchanger inlet 26 is connected to the fluid pathways 20 via an inlet manifold 30 to distribute the flow of fluid 22 to the fluid pathways 20, and similarly the heat exchanger outlet 24 is connected to the fluid pathways 20 via an outlet manifold 28. Immediately downstream of the inlet manifold 30, orifices 80 of different diameters, increasing with increasing distance from the heat exchanger inlet 26 are provided to distribute the flow of fluid 22 from the inlet manifold 30 equally among all of the fluid pathways 20. The enhancement features described in the following text will be in the fluid pathways 20 downstream of the respective orifices 80.

In some embodiments, the heat exchanger 14 is formed from a metal material, such as aluminum, aluminum alloy, steel, steel alloy, copper, copper alloy, or the like, and referring again to FIG. 1, may be formed from two or more plates 32, 34 abutting one another along a side and joined using any suitable means such as brazing, welding, clamping, compressing, bolting, and the like. The plates 32, 34 may each include a portion of the fluid pathways 20, the inlet manifold 30, the outlet manifold 28, the heat exchanger inlet 26 and/or the heat exchanger outlet 24 formed therein. The mating surfaces of the plates 32, 34 can be configured to correspond to one another, e.g., to fit together and seal the fluid circuit therebetween. The mating surfaces of the plates 32, 34 can include precision surfaces formed from a process having highly accurate and precise dimensional control, such as through computer numerical control (CNC) machining process and/or net shape, or near net shape manufacturing process. Optionally or additionally, a sealing material can be disposed between the plates 32, 34 to aide in preventing leakage from the fluid circuit.

In operation, the flow of fluid 22, liquid refrigerant from the condenser 72, enters the heat exchanger 14 at the heat exchanger inlet 26 and is distributed to the fluid pathways 20 via the inlet manifold 30. The heat exchanger 14 conducts thermal energy from the power electronics devices 12 and thermal energy is exchanged with the flow of fluid 22 flowing through the fluid pathways 20, resulting in cooling of the power electronics devices 12. The vapor flow of fluid 22 is then collected at the outlet manifold 28 and exits the heat exchanger 14 at the heat exchanger outlet 24. The flow of fluid 22 provided to the heat exchanger 14 is diverted from the condenser 72 and in some embodiments enters the heat exchanger 14 in a liquid phase with 0% vapor quality or up to 20% vapor quality. The presently disclosed heat exchanger 14 may be operated to ensure the vapor quality of the flow of fluid 22 exiting the heat exchanger 14 has a vapor quality of from about 25% to about 80%, or in another embodiment from about 40% to about 60%, or in yet another embodiment from about 45% to about 55%, or about 50%. The vapor quality change happens as the heat from power electronics devices 12 is absorbed by the flow and used for phase change of the liquid refrigerant to vapor while travelling from the heat exchanger inlet 26 to the heat exchanger outlet 24. In the present disclosure, features of the heat exchanger 14 are disclosed which improve performance of the heat exchanger 14, many of which are features to improve boiling performance of the flow of fluid 22, the refrigerant from the condenser 72.

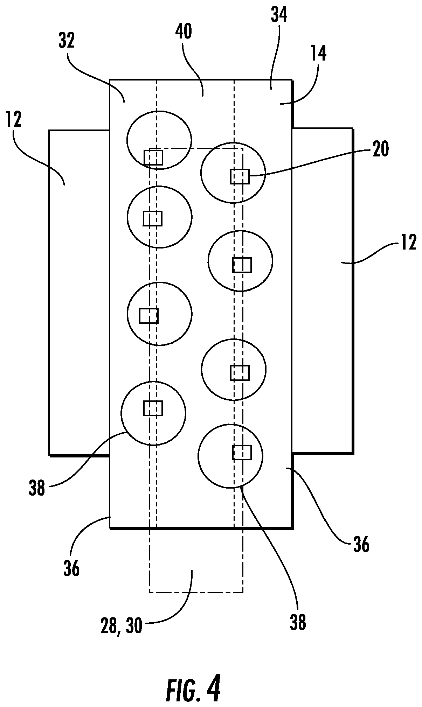

Referring now to FIG. 4, power electronics devices 12 are installed to both lateral sides 36 of the heat exchanger 14. To accomplish cooling of the power electronics devices 12 in such configurations, the heat exchanger 14 may have one, or two or more pathway columns 38 of fluid pathways 20 arranged between the lateral sides 36. This may increase the flow of fluid 22 through the heat exchanger 14, and enable the fluid 22 to be in closer proximity to the respective power electronics devices 12 (as compared to a single column positioned in the center of the lateral sides 36). In such configurations, the heat exchanger 14 may have an additional middle plate 40 between the plates 32, 34 in which a portion of each pathway column 38 is formed. The columns can be adjacent to each other to increase thermal mass of the heat exchanger 14 or in a staggered arrangement to reduce the thermal mass hence weight of the heat exchanger 14.

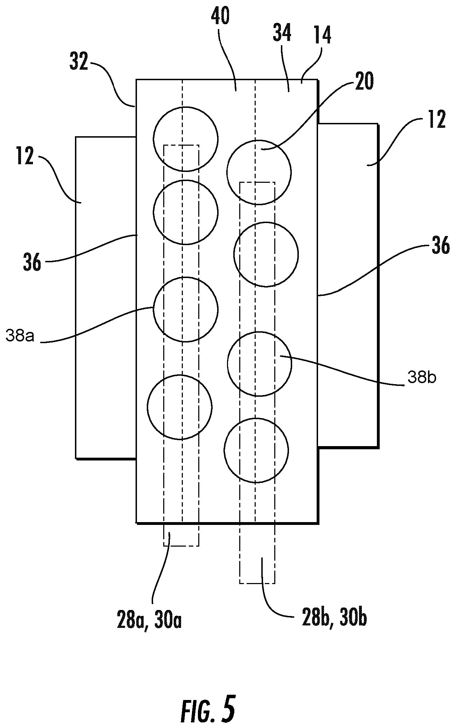

In some embodiments, such as shown in FIG. 4, the two pathway columns 38 share a common inlet manifold 30 and a common outlet manifold 28. In other embodiments, such as illustrated in FIG. 5, a first pathway column 38a utilizes a first inlet manifold 30a and a first outlet manifold 28a having a first flow of fluid 22a defining a first circuit. Similarly, a second pathway column 38b utilizes a second inlet manifold 30b and a second outlet manifold 28b having a second flow of fluid 22b defining a second circuit. Having separate first and second circuits in the heat exchanger 14 allows for the flow of each fluid 22a, 22b to be tuned separately to meet the cooling requirements for the power electronics devices at each lateral side 36 of the heat exchanger 14. For example, in some embodiments, the fluid pathways 20a of the first pathway column 38a may be the same configuration as the fluid pathways 20b of the second pathway column 38b, or the configurations may be different having, for example, different pathway sizes, internal or external features, different materials, or the like. Further, a number of pathways in each of the pathway columns 38a, 38b may differ and/or a different fluid may be circulated in each pathway column 38a, 38b.

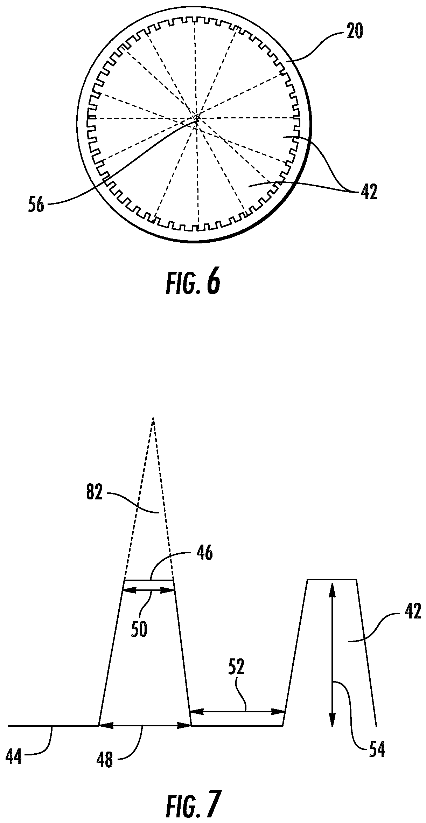

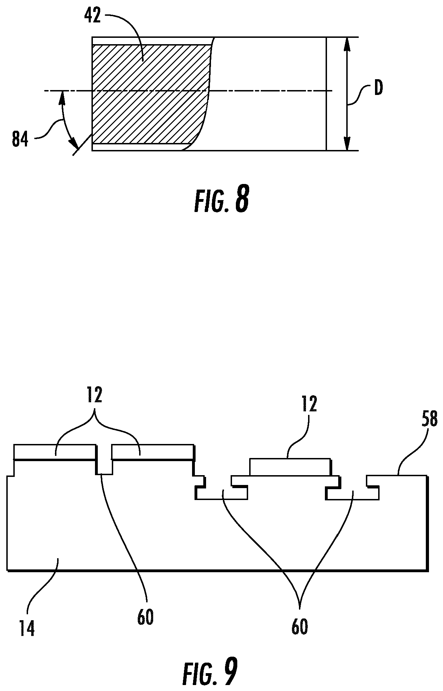

Referring now to FIG. 6 and 7, in some embodiments, the fluid pathways 20 include a plurality of fins 42 extending radially inwardly from a pathway inner wall 44 to a fin tip 46. Each fin 42 has a circumferential base width 48 and a circumferential tip width 50, as well as a circumferential fin spacing 52 between adjacent fins 42, defined at the pathway inner wall 44. In some embodiments, the tip width 50 is in the range of 0.01 millimeters to 0.1 millimeters. Additionally, the fin spacing 52 may be in the range of 0.05 millimeters and 0.5 millimeters. The fins 42 further each have a fin height 54 from the pathway inner wall 44 to the fin tip 46. The fin height 54 may be in a range of, for example, 0.2 millimeters to 0.5 millimeters, depending on a pathway hydraulic diameter, which in some embodiments is in the range of 5 millimeters to 20 millimeters. In some embodiments, a number of fins 42 in a fluid pathway 20 is in the range of 30-80 fins 42. The plurality of fins 42 may extend substantially linearly parallel to a pathway central axis 56 or alternatively may extend helically about the pathway central axis 56 along a length of the pathway 20, at a helix angle 82 in the range of 10 degrees to 30 degrees, such as shown in FIG. 8. Additionally, referring again to FIG. 7, the fins 42 have an apex angle 84 between adjacent sidewalls of the fins 42, which may be in the range of 20 degrees to 60 degrees.

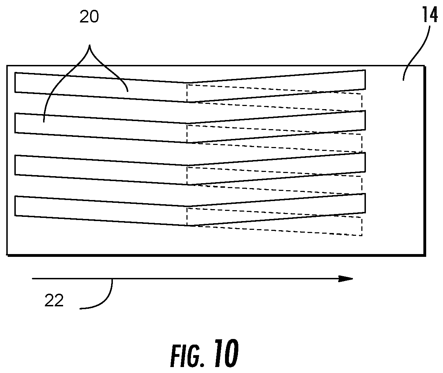

Referring now to FIG. 9, a heat exchanger outer wall 58 may include condensate drainage passages 60 located between adjacent power electronics devices 12. During operation, condensate may form on the cooler walls of the heat exchanger outer wall 58. The condensate drainage passages 60, when present, collect the condensate and drain the condensate away from the power electronics devices 12. In some embodiments, the condensate drainage passages 60 have a T-shaped cross-section to contain the condensate and drain the condensate away from the power electronics devices. Referring now to FIG. 10, the fluid pathways 20 may extend in a direction off of horizontal along the fluid pathway length. This promotes drainage of the flow of fluid 22 from the heat exchanger 14 via gravity when the HVAC system 18 is deactivated. In some embodiments, such as shown, the fluid pathways 20 are chevron-shaped along the fluid pathway length, while in other embodiments the fluid pathways 20 are simply inclined in one direction relative to horizontal. Other configurations of fluid pathways 20 are contemplated within the scope of the present disclosure.

The configurations of heat exchangers 14 and power electronics assemblies 10 disclosed herein increase heat transfer area in the fluid pathways 20 and promote convective evaporation and boiling of the flow of fluid 22 in the heat exchanger 14 to improve heat transfer rate of the heat exchanger 14. Further, the configurations reduce a volume of heat exchanger 14 for cooling the power electronics devices 12.

## Claims

1. A heating, ventilation, and air conditioning (HVAC) system (18), comprising:
a vapour compression circuit (7) including a compressor (16), a condenser (72), an expansion device (74) and an evaporator (76) arranged in series and having a volume of refrigerant flowing therethrough; and
a power electronics assembly (10), the power electronics assembly comprising:
two or more power electronics devices (12); and
a heat exchanger (14) to which the two or more power electronics devices (12) are mounted, the heat exchanger (14) comprising:
a plurality of fluid pathways (20, 20a, 20b) extending through the heat exchanger (14) to transfer thermal energy from the two or more power electronics devices (12) into a flow of fluid (22, 22a, 22b) passing through the plurality of fluid pathways (20, 20a, 20b);
wherein the two or more power electronics devices (12) includes at least one power electronics device (12) of the two or more power electronics devices located on each opposing lateral side (36) of the heat exchanger (14);
wherein the flow of fluid (22, 22a, 22b) passing through the plurality of fluid pathways (20, 20a, 20b) is a flow of liquid refrigerant diverted from the condenser (72) of the heating, ventilation, and air conditioning (HVAC) system (18),
wherein the refrigerant is diverted from the condenser (72), bypassing the expansion device (74) of the HVAC system and is directed from the heat exchanger (14) to the evaporator (76),
wherein the fluid flow exiting the one or more fluid pathways (20, 20a, 20b) is directed through the evaporator (76) prior to flowing through the compressor (16).

2. The heating, ventilation, and air conditioning (HVAC) system (18) of claim 1, wherein the heat exchanger (14) includes multiple columns (38, 38a, 38b) of the fluid pathways (20, 20a, 20b) arranged between the opposing lateral sides (36) of the heat exchanger (14).

3. The heating, ventilation, and air conditioning (HVAC) system (18) of claim 2, wherein each column (38a, 38b) of the multiple columns of fluid pathways (20a, 20b) defines an independent fluid circuit.

4. The heating, ventilation, and air conditioning (HVAC) system (18) of claims 2 or 3, wherein each column (38, 38a, 38b) of fluid pathways (20, 20a, 20b) is configured to cool the at least one power electronics device (12) of the two or more power electronics devices at the lateral side (36) of the heat exchanger (14) nearest each column (38, 38a, 38b).

5. The heating, ventilation, and air conditioning (HVAC) system (18) of any preceding claim, wherein the plurality of fluid pathways (20, 20a, 20b) include one or more fins (42) extending inwardly from a pathway inner wall (44);
wherein optionally each fin (42) of the one or more fins (42) has a fin height (54) in the range of 0.2 millimeters to 0.5 millimeters.

6. The heating, ventilation, and air conditioning (HVAC) system (18) of any preceding claim, further comprising one or more condensate drainage passages (60) formed in an exterior surface (58) of the heat exchanger (14) configured to drain condensate formed on one or more of the two or more power electronics devices (12) or on the heat exchanger (14);

7. The heating, ventilation, and air conditioning (HVAC) system (18) of claim 6, wherein the one or more condensate drainage passages (60) have a T-shaped cross-section.

8. The heating, ventilation, and air conditioning (HVAC) system (18) of any preceding claim, wherein the plurality of fluid pathways (20, 20a, 20b) extend off of horizontal along a fluid pathway length.

9. A method of cooling two or more power electronics devices (12), comprising:
securing the two or more power electronics devices (12) to a heat exchanger (14), the heat exchanger (14) comprising a plurality of fluid pathways (20, 20a, 20b);
circulating a flow of fluid (22, 22a, 22b) through the plurality of fluid pathways (20, 20a, 20b) to transfer thermal energy from the two or more power electronics devices (12) to the flow of fluid (22, 22a, 22b) passing through the plurality of fluid pathways (20, 20a, 20b);
wherein the flow of fluid (22, 22a, 22b) is a flow of liquid refrigerant diverted from a condenser (72) of a heating, ventilation, and air conditioning (HVAC) system (18), the heating, ventilation, and air conditioning (HVAC) system (18) comprising a vapour compression circuit (7) including a compressor (16), the condenser (72), an expansion device (74) and an evaporator (76) arranged in series and having a volume of refrigerant flowing therethrough;
wherein the flow of fluid (22, 22a, 22b) circulated through the plurality of fluid pathways (20, 20a, 20b) is diverted from the condenser (72), bypassing the expansion device (74) of the HVAC system and is directed from the heat exchanger (14) to the evaporator (76),
wherein the fluid flow exiting the one or more fluid pathways (20, 20a, 20b) is directed through the evaporator (76) prior to flowing through the compressor (16),
wherein at least one power electronics device (12) of the two or more power electronics devices is located on each opposing lateral side (36) of the heat exchanger (14).

10. The method of claim 9, wherein the heat exchanger includes multiple columns (38, 38a, 38b) of the fluid pathways (20) arranged between the opposing lateral sides (36) of the heat exchanger (14).

11. The method of claim 10, further comprising:
circulating a first flow of fluid (22, 22a) through a first column (38a, 38) of fluid pathways (20, 20a); and
circulating a second flow of fluid (22b, 22b) through a second column (38b, 38) of fluid pathways (20, 20b).

12. The method of claim 11, further comprising:
cooling a first power electronics device (12) disposed at a first lateral side (36) of the heat exchanger (14) via the first flow of fluid (22, 22a); and
cooling a second power electronics device (12) disposed at a second lateral side (36) of the heat exchanger (14) via the second flow of fluid (22, 22b).

13. The method of any of claims 9 to 12, wherein the plurality of fluid pathways (20, 20a, 20b) include one or more fins (42) extending inwardly from a pathway inner wall (44);
wherein optionally each fin (42) of the one or more fins (42) has a fin height (54) in the range of 0.2 millimeters to 0.5 millimeters.

14. The method of any of claims 9 to 13, further comprising draining condensate formed on one or more of the two or more power electronics devices (12) or on the heat exchanger (14) via one or more condensate drainage passages (60) formed in an exterior surface (58) of the heat exchanger (14);
wherein optionally the one or more condensate drainage passages (60) have a T-shaped cross-section.

15. The method of any of claims 9 to 14, wherein the plurality of fluid pathways (20, 20a, 20b) extend off or horizontal along a fluid pathway length.

## Patentansprüche

1. Heizungs-, Lüftungs- und Klimaanlagen-(HLK-)System (18), umfassend:
einen Dampfkompressionskreislauf (7), der einen Verdichter (16), einen Verflüssiger (72), eine Entspannungsvorrichtung (74) und einen Verdampfer (76) beinhaltet, die in Reihe angeordnet sind und durch die ein Volumen an Kältemittel strömt; und
eine Leistungselektronikanordnung (10), wobei die Leistungselektronikanordnung umfasst:
zwei oder mehr Leistungselektronikvorrichtungen (12); und
einen Wärmetauscher (14), an dem die zwei oder mehr Leistungselektronikvorrichtungen (12) montiert sind, wobei der Wärmetauscher (14) umfasst:
eine Vielzahl von Fluidpfaden (20, 20a, 20b), die sich durch den Wärmetauscher (14) erstrecken, um thermische Energie von den zwei oder mehr Leistungselektronikvorrichtungen (12) in einen Strom von Fluid (22, 22a, 22b) zu übertragen, der durch die Vielzahl von Fluidpfaden (20, 20a, 20b) verläuft;
wobei die zwei oder mehr Leistungselektronikvorrichtungen (12) mindestens eine Leistungselektronikvorrichtung (12) der zwei oder mehr Leistungselektronikvorrichtungen beinhalten, die an jeder gegenüberliegenden lateralen Seite (36) des Wärmetauschers (14) angeordnet ist;
wobei der Strom von Fluid (22, 22a, 22b), der durch die Vielzahl von Fluidpfaden (20, 20a, 20b) verläuft, ein Strom von flüssigem Kältemittel ist, der von dem Verflüssiger (72) des Heizungs-, Lüftungs- und Klimaanlagen-(HLK-)Systems (18) abgezweigt wird,
wobei das Kältemittel von dem Verflüssiger (72) unter Umgehung der Entspannungsvorrichtung (74) des HLK-Systems abgezweigt wird und von dem Wärmetauscher (14) zu dem Verdampfer (76) geleitet wird,
wobei der Fluidstrom, der aus dem einen oder den mehreren Fluidpfaden (20, 20a, 20b) austritt, durch den Verdampfer (76) geleitet wird, bevor er durch den Verdichter (16) strömt.

2. Heizungs-, Lüftungs- und Klimaanlagen-(HLK-)System (18) nach Anspruch 1, wobei der Wärmetauscher (14) mehrere Spalten (38, 38a, 38b) der Fluidpfade (20, 20a, 20b) beinhaltet, die zwischen den gegenüberliegenden lateralen Seiten (36) des Wärmetauschers (14) angeordnet sind.

3. Heizungs-, Lüftungs- und Klimaanlagen-(HLK-)System (18) nach Anspruch 2, wobei jede Spalte (38a, 38b) der mehreren Spalten von Fluidpfaden (20a, 20b) einen unabhängigen Fluidkreislauf definiert.

4. Heizungs-, Lüftungs- und Klimaanlagen-(HLK-)System (18) nach Anspruch 2 oder 3, wobei jede Spalte (38, 38a, 38b) von Fluidpfaden (20, 20a, 20b) konfiguriert ist, um die mindestens eine Leistungselektronikvorrichtung (12) der zwei oder mehr Leistungselektronikvorrichtungen an der lateralen Seite (36) des Wärmetauschers (14) zu kühlen, die jeder Spalte (38, 38a, 38b) am nächsten liegt.

5. Heizungs-, Lüftungs- und Klimaanlagen-(HLK-)System (18) nach einem der vorhergehenden Ansprüche, wobei die Vielzahl von Fluidpfaden (20, 20a, 20b) eine oder mehrere Rippen (42) beinhaltet, die sich von einer Pfadinnenwand (44) nach innen erstrecken;
wobei optional jede Rippe (42) der einen oder mehreren Rippen (42) eine Rippenhöhe (54) im Bereich von 0,2 Millimetern bis 0,5 Millimetern aufweist.

6. Heizungs-, Lüftungs- und Klimaanlagen-(HLK-)System (18) nach einem der vorhergehenden Ansprüche, ferner umfassend einen oder mehrere Kondensatablaufkanäle (60), die in einer Außenoberfläche (58) des Wärmetauschers (14) ausgebildet sind und konfiguriert sind, um Kondensat abzuleiten, das sich auf einer oder mehreren der zwei oder mehr Leistungselektronikvorrichtungen (12) oder auf dem Wärmetauscher (14) gebildet hat;

7. Heizungs-, Lüftungs- und Klimaanlagen-(HLK-)System (18) nach Anspruch 6, wobei der eine oder die mehreren Kondensatablaufkanäle (60) einen T-förmigen Querschnitt aufweisen.

8. Heizungs-, Lüftungs- und Klimaanlagen-(HLK-)System (18) nach einem der vorhergehenden Ansprüche, wobei sich die Vielzahl von Fluidpfaden (20, 20a, 20b) entlang einer Fluidpfadlänge abweichend von der Horizontalen erstreckt.

9. Verfahren zum Kühlen von zwei oder mehr Leistungselektronikvorrichtungen (12), umfassend:
Befestigen der zwei oder mehr Leistungselektronikvorrichtungen (12) an einem Wärmetauscher (14), wobei der Wärmetauscher (14) eine Vielzahl von Fluidpfaden (20, 20a, 20b) umfasst;
Zirkulieren eines Stroms von Fluid (22, 22a, 22b) durch die Vielzahl von Fluidpfaden (20, 20a, 20b), um thermische Energie von den zwei oder mehr Leistungselektronikvorrichtungen (12) auf den Strom von Fluid (22, 22a, 22b) zu übertragen, der durch die Vielzahl von Fluidpfaden (20, 20a, 20b) verläuft;
wobei der Strom von Fluid (22, 22a, 22b) ein Strom von flüssigem Kältemittel ist, der von einem Verflüssiger (72) eines Heizungs-, Lüftungs- und Klimaanlagen-(HLK-)Systems (18) abgezweigt wird, wobei das Heizungs-, Lüftungs- und Klimaanlagen- (HLK-) System (18) einen Dampfkompressionskreislauf (7) umfasst, der einen Verdichter (16), den Verflüssiger (72), eine Entspannungsvorrichtung (74) und einen Verdampfer (76) beinhaltet, die in Reihe angeordnet sind und durch die ein Volumen an Kältemittel strömt;
wobei der Strom von Fluid (22, 22a, 22b), der durch die Vielzahl von Fluidpfaden (20, 20a, 20b) zirkuliert wird, von dem Verflüssiger (72) unter Umgehung der Entspannungsvorrichtung (74) des HLK-Systems abgezweigt wird und von dem Wärmetauscher (14) zu dem Verdampfer (76) geleitet wird,
wobei der Fluidstrom, der aus dem einen oder den mehreren Fluidpfaden (20, 20a, 20b) austritt, durch den Verdampfer (76) geleitet wird, bevor er durch den Verdichter (16) strömt,
wobei mindestens eine Leistungselektronikvorrichtung (12) der zwei oder mehr Leistungselektronikvorrichtungen an jeder gegenüberliegenden lateralen Seite (36) des Wärmetauschers (14) angeordnet ist.

10. Verfahren nach Anspruch 9, wobei der Wärmetauscher mehrere Spalten (38, 38a, 38b) der Fluidpfade (20) beinhaltet, die zwischen den gegenüberliegenden lateralen Seiten (36) des Wärmetauschers (14) angeordnet sind.

11. Verfahren nach Anspruch 10, ferner umfassend:
Zirkulieren eines ersten Stroms von Fluid (22, 22a) durch eine erste Spalte (38a, 38) von Fluidpfaden (20, 20a); und
Zirkulieren eines zweiten Stroms von Fluid (22b, 22b) durch eine zweite Spalte (38b, 38) von Fluidpfaden (20, 20b).

12. Verfahren nach Anspruch 11, ferner umfassend:
Kühlen einer ersten Leistungselektronikvorrichtung (12), die an einer ersten lateralen Seite (36) des Wärmetauschers (14) angeordnet ist, über den ersten Strom von Fluid (22, 22a); und
Kühlen einer zweiten Leistungselektronikvorrichtung (12), die an einer zweiten lateralen Seite (36) des Wärmetauschers (14) angeordnet ist, über den zweiten Strom von Fluid (22, 22b).

13. Verfahren nach einem der Ansprüche 9 bis 12, wobei die Vielzahl von Fluidpfaden (20, 20a, 20b) eine oder mehrere Rippen (42) beinhaltet, die sich von einer Pfadinnenwand (44) nach innen erstrecken;
wobei optional jede Rippe (42) der einen oder mehreren Rippen (42) eine Rippenhöhe (54) im Bereich von 0,2 Millimetern bis 0,5 Millimetern aufweist.

14. Verfahren nach einem der Ansprüche 9 bis 13, ferner umfassend das Ableiten von Kondensat, das sich auf einer oder mehreren der zwei oder mehr Leistungselektronikvorrichtungen (12) oder auf dem Wärmetauscher (14) gebildet hat, über einen oder mehrere Kondensatablaufkanäle (60), die in einer Außenoberfläche (58) des Wärmetauschers (14) ausgebildet sind;
wobei optional der eine oder die mehreren Kondensatablaufkanäle (60) einen T-förmigen Querschnitt aufweisen.

15. Verfahren nach einem der Ansprüche 9 bis 14, wobei sich die Vielzahl von Fluidpfaden (20, 20a, 20b) entlang einer Fluidpfadlänge abweichend von der Horizontalen erstreckt.

## Revendications

1. Système de chauffage, ventilation et climatisation (HVAC) (18), comprenant :
un circuit de compression de vapeur (7) comportant un compresseur (16), un condenseur (72), un détendeur (74) et un évaporateur (76) agencés en série et présentant un volume de fluide frigorigène qui s'y écoule ; et
un ensemble d'électronique de puissance (10), l'ensemble d'électronique de puissance comprenant :
deux ou plus dispositifs d'électronique de puissance (12) ; et
un échangeur de chaleur (14) sur lequel sont montés les deux ou plus dispositifs d'électronique de puissance (12), l'échangeur de chaleur (14) comprenant :
une pluralité de trajets de fluide (20, 20a, 20b) s'étendant à travers l'échangeur de chaleur (14) pour transférer l'énergie thermique des deux ou plus dispositifs d'électronique de puissance (12) dans un flux de fluide (22, 22a, 22b) passant à travers la pluralité de trajets de fluide (20, 20a, 20b) ;
dans lequel les deux ou plus dispositifs d'électronique de puissance (12) comportent au moins un dispositif d'électronique de puissance (12) des deux ou plus dispositifs d'électronique de puissance situé sur chaque côté latéral opposé (36) de l'échangeur de chaleur (14) ;
dans lequel le flux de fluide (22, 22a, 22b) passant à travers la pluralité de trajets de fluide (20, 20a, 20b) est un flux de fluide frigorigène liquide dérivé du condenseur (72) du système de chauffage, ventilation et climatisation (HVAC) (18),
dans lequel le fluide frigorigène est dérivé du condenseur (72), contournant le détendeur (74) du système HVAC et est dirigé de l'échangeur de chaleur (14) vers l'évaporateur (76),
dans lequel le flux de fluide sortant du un ou des plusieurs trajets de fluide (20, 20a, 20b) est dirigé à travers l'évaporateur (76) avant de passer à travers le compresseur (16).

2. Système de chauffage, ventilation et climatisation (HVAC) (18) selon la revendication 1, dans lequel l'échangeur de chaleur (14) comporte plusieurs colonnes (38, 38a, 38b) des trajets de fluide (20, 20a, 20b) agencés entre les côtés latéraux opposés (36) de l'échangeur de chaleur (14).

3. Système de chauffage, ventilation et climatisation (HVAC) (18) selon la revendication 2, dans lequel chaque colonne (38a, 38b) des plusieurs colonnes de trajets de fluide (20a, 20b) définit un circuit de fluide indépendant.

4. Système de chauffage, ventilation et climatisation (HVAC) (18) selon les revendications 2 ou 3, dans lequel chaque colonne (38, 38a, 38b) de trajets de fluide (20, 20a, 20b) est configurée pour refroidir le au moins un dispositif d'électronique de puissance (12) des deux ou plus dispositifs d'électronique de puissance au niveau du côté latéral (36) de l'échangeur de chaleur (14) le plus proche de chaque colonne (38, 38a, 38b).

5. Système de chauffage, ventilation et climatisation (HVAC) (18) selon une quelconque revendication précédente, dans lequel la pluralité de trajets de fluide (20, 20a, 20b) comportent une ou plusieurs ailettes (42) s'étendant vers l'intérieur à partir d'une paroi intérieure de trajet (44) ;
dans lequel éventuellement chaque ailette (42) de la une ou des plusieurs ailettes (42) présente une hauteur d'ailette (54) comprise entre 0,2 millimètre et 0,5 millimètre.

6. Système de chauffage, ventilation et climatisation (HVAC) (18) selon une quelconque revendication précédente, comprenant en outre un ou plusieurs passages d'évacuation des condensats (60) formés dans une surface extérieure (58) de l'échangeur de chaleur (14) configurés pour évacuer les condensats formés sur l'un ou plusieurs des deux ou plus dispositifs d'électronique de puissance (12) ou sur l'échangeur de chaleur (14) ;

7. Système de chauffage, ventilation et climatisation (HVAC) (18) selon la revendication 6, dans lequel le un ou les plusieurs passages d'évacuation des condensats (60) présentent une section transversale en forme de T.

8. Système de chauffage, ventilation et climatisation (HVAC) (18) selon une quelconque revendication précédente, dans lequel la pluralité de trajets de fluide (20, 20a, 20b) s'étendent au-delà de l'horizontale le long d'une longueur de trajet de fluide .

9. Procédé de refroidissement de deux ou plus dispositifs d'électronique de puissance (12), comprenant :
la fixation des deux ou plus dispositifs d'électronique de puissance (12) à un échangeur de chaleur (14), l'échangeur de chaleur (14) comprenant une pluralité de trajets de fluide (20, 20a, 20b) ;
la circulation d'un flux de fluide (22, 22a, 22b) à travers la pluralité de trajets de fluide (20, 20a, 20b) pour transférer l'énergie thermique des deux ou plus dispositifs d'électronique de puissance (12) vers le flux de fluide (22, 22a, 22b) passant à travers la pluralité de trajets de fluide (20, 20a, 20b) ;
dans lequel le flux de fluide (22, 22a, 22b) est un flux de fluide frigorigène liquide dérivé d'un condenseur (72) d'un système de chauffage, ventilation et climatisation (HVAC) (18),
le système de chauffage, ventilation et climatisation (HVAC) (18) comprenant un circuit de compression de vapeur (7) comportant un compresseur (16), le condenseur (72), un détendeur (74) et un évaporateur (76) agencés en série et présentant un volume de fluide frigorigène qui s'y écoule ;
dans lequel le flux de fluide (22, 22a, 22b) qui circule à travers la pluralité de trajets de fluide (20, 20a, 20b) est dérivé du condenseur (72), contournant le détendeur (74) du système HVAC et est dirigé de l'échangeur de chaleur (14) vers l'évaporateur (76),
dans lequel le flux de fluide sortant du un ou des plusieurs trajets de fluide (20, 20a, 20b) est dirigé à travers l'évaporateur (76) avant de passer à travers le compresseur (16),
dans lequel au moins un dispositif d'électronique de puissance (12) des deux ou plus dispositifs d'électronique de puissance est situé sur chaque côté latéral opposé (36) de l'échangeur de chaleur (14).

10. Procédé selon la revendication 9, dans lequel l'échangeur de chaleur comporte plusieurs colonnes (38, 38a, 38b) des trajets de fluide (20) agencés entre les côtés latéraux opposés (36) de l'échangeur de chaleur (14).

11. Procédé selon la revendication 10, comprenant en outre :
la circulation d'un premier flux de fluide (22, 22a) à travers une première colonne (38a, 38) de trajets de fluide (20, 20a) ; et
la circulation d'un second flux de fluide (22b, 22b) à travers une seconde colonne (38b, 38) de trajets de fluide (20, 20b).

12. Procédé selon la revendication 11, comprenant en outre :
le refroidissement d'un premier dispositif d'électronique de puissance (12) disposé au niveau d'un premier côté latéral (36) de l'échangeur de chaleur (14) par l'intermédiaire du premier flux de fluide (22, 22a) ; et
le refroidissement d'un second dispositif d'électronique de puissance (12) disposé au niveau d'un second côté latéral (36) de l'échangeur de chaleur (14) par l'intermédiaire du second flux de fluide (22, 22b).

13. Procédé selon l'une quelconque des revendications 9 à 12, dans lequel la pluralité de trajets de fluide (20, 20a, 20b) comportent une ou plusieurs ailettes (42) s'étendant vers l'intérieur à partir d'une paroi intérieure de trajet (44) ;
dans lequel éventuellement chaque ailette (42) de la une ou des plusieurs ailettes (42) présente une hauteur d'ailette (54) comprise entre 0,2 millimètre et 0,5 millimètre.

14. Procédé selon l'une quelconque des revendications 9 à 13, comprenant en outre l'évacuation des condensats formés sur l'un ou plusieurs des deux ou plus dispositifs d'électronique de puissance (12) ou sur l'échangeur de chaleur (14) par l'intermédiaire d'un ou de plusieurs passages d'évacuation des condensats (60) formés dans une surface extérieure (58) de l'échangeur de chaleur (14) ;
dans lequel éventuellement le un ou les plusieurs passages d'évacuation des condensats (60) présentent une section transversale en forme de T.

15. Procédé selon l'une quelconque des revendications 9 à 14, dans lequel la pluralité de trajets de fluide (20, 20a, 20b) s'étendent au-delà ou horizontalement le long d'une longueur de trajet de fluide.
